# EUROPEAN PATENT APPLICATION

(11) **EP 4 096 371 A1**
(43) Date of publication of application: **30.11.2022**
(21) Application number: 20924183.5
(22) Date of filing: 14.07.2020
(51) Int. Cl.: H05K 1/11

(54) **CIRCUIT BOARD STRUCTURE AND ELECTRONIC DEVICE**

(30) Priority: 13.03.2020 CN 202020317937 U
(71) Applicant: Huawei Technologies Co., Ltd., Shenzhen, Guangdong 518129 (CN)
(72) Inventor: SHI, Hongbin, Shenzhen, Guangdong 518129 (CN); CHEN, Xi, Shenzhen, Guangdong 518129 (CN); TU, Haisheng, Shenzhen, Guangdong 518129 (CN)
(74) Representative: Goddar, Heinz J.
(86) International application number: PCT/CN2020/101905
(87) International publication number: WO 2021/179504

(57) **Abstract**

This application discloses a circuit board structure (30), including a main body (320) and a plurality of pads (310). A chip mounting region (330) is disposed on a surface of the main body (320), the plurality of pads (310) include at least one first pad (311) and a plurality of second pads (312), the at least one first pad (311) is located near a corner of the chip mounting region (330), the plurality of second pads (312) are distributed in a central region (331) of the chip mounting region (330) and around the at least one first pad (311), an area of the first pad (311) is twice greater than an area of the second pad (312), and the first pad (311) is configured to solder at least two independent pads (310) on a chip (20) side. In the circuit board, the first pad (311) is disposed in an edge region (332) of the chip mounting region (330), and the area of the first pad (311) is twice greater than the area of the second pad (312). This design increases a bonding area between the pads (310) and the chip (20), and resolves a mechanical reliability problem of connection between the chip (20) and the circuit board structure (30), so that an amount of glue dispensed between the chip (20) and the circuit board structure (30) can be reduced or even no glue is dispensed between the chip (20) and the circuit board structure (30), thereby avoiding the following problems in glue dispensing: dewetting of a solder joint of a glue dispensing element during repair, an adhesive failure of a sensitive element, an increase in costs, and the like.

## Description

This application claims priority to Chinese Patent Application No. 202020317937.2, filed with the China National Intellectual Property Administration on March 13, 2020 and entitled "CIRCUIT BOARD STRUCTURE AND ELECTRONIC DEVICE", which is incorporated herein by reference in its entirety.

### TECHNICAL FIELD

This application relates to the field of circuit board technologies, and in particular, to a circuit board structure configured to solder a chip, and an electronic device.

### BACKGROUND

To resolve a mechanical reliability problem of a solder joint of a large-sized chip such as an AP (Application Processor, application processor) or a UFS (Universal Flash Storage, universal flash storage), and the following problems in solder joint glue dispensing between the chip and a PCB: dewetting of a solder joint of a glue dispensing element during repair, an adhesive failure of a sensitive element, increases in costs and process complexity, and the like, a mechanical reliability improvement technology between the chip and the circuit board structure needs to be developed to substitute for glue dispensing.

### SUMMARY

This application provides a circuit board structure, and a mechanical reliability problem of connection between the circuit board structure and a chip is resolved by designing pads of the circuit board structure.

According to a first aspect, this application provides a circuit board structure, including a main body and a plurality of pads. A chip mounting region is disposed on a surface of the main body, the plurality of pads include at least one first pad and a plurality of second pads, the at least one first pad is located near a corner of the chip mounting region, the plurality of second pads are distributed in a central region of the chip mounting region and around the at least one first pad, an area of the first pad is twice greater than an area of the second pad, and the first pad is configured to solder at least two independent pads on a chip side.

In this application, the first pad is disposed in an edge region of the chip mounting region, and the area of the first pad is twice greater than the area of the second pad, thereby resolving a mechanical reliability problem of connection between a large-sized chip and the circuit board structure. Specifically, during falling of the circuit board structure, due to being subject to a relatively large stress, pads in the edge region have poor reliability and are prone to crack. Therefore, the large-sized first pad is disposed in the edge region, thereby increasing bonding areas between the pads and the chip and the main body of the circuit board structure, to prevent the pads from cracking during falling, thereby improving mechanical reliability of connection between the chip and the circuit board structure. Due to enhancement of mechanical reliability, an amount of glue dispensed between the chip and the circuit board structure can be reduced or even no glue is dispensed between the chip and the circuit board structure, thereby effectively avoiding the following problems in pad glue dispensing between the chip and the circuit board structure: dewetting of a solder joint of a glue dispensing element during repair, an adhesive failure of a sensitive element, increases in costs and process complexity, and the like.

In a possible implementation, the at least one first pad is electrically connected to a ground plane of the main body, the at least one first pad is a non-functional pad, or the at least one first pad is a network function pad. In other words, the at least one first pad may be a ground pad, a non-functional pad, or a network function pad. The ground pad is connected to the ground plane of the main body. The non-functional pad is usually disposed at four corners and an outside ring of the chip mounting region, to physically connect the chip and the circuit board structure, thereby protecting functional pads inside the chip from first cracking when being subjected to mechanical and environmental stresses, affecting a product function. A plurality of independent pads having a same network function may be combined into a large-sized first pad.

In a possible implementation, the chip mounting region includes a first side edge region, a second side edge region, a third side edge region, and a fourth side edge region that are located on a peripheral of the central region and that are sequentially connected, the first side edge region and the third side edge region are oppositely disposed on two sides of the central region, the second side edge region and the fourth side edge region are oppositely disposed on two sides of the central region, first pads electrically connected to the ground plane of the main body are distributed in the first side edge region and the third side edge region, and network function pads are distributed in the second side edge region and the fourth side edge region.

In a possible implementation, the network function pad is electrically connected to a signal plane of the main body.

In a possible implementation, the chip mounting region is square, first pads are distributed at four corners of the chip mounting region, and a size of each first pad is twice to four times a size of the second pad. A pad at a corner is prone to crack when being subjected to mechanical and environmental stresses. Therefore, the large-sized first pads are distributed at the four corners, thereby helping improve mechanical reliability of connection between the chip and the circuit board structure.

In a possible implementation, the chip mounting region is square, the chip mounting region is divided into an N^{∗}N matrix region, first pads are located at four corners of the chip mounting region, and the first pads are distributed in 8^{∗}8 matrix regions. A pad in an 8^{∗}8 matrix region at a corner is prone to crack. Therefore, large-sized first pads are distributed in each 8^{∗}8 matrix region at a corner, thereby improving mechanical reliability of connection between the chip and the circuit board structure.

In a possible implementation, the chip mounting region includes the central region and the edge region, the edge region is in a frame shape and surrounds the central region, a plurality of rings of pads are distributed in the edge region, the first pads are distributed in the edge region, a solder mask layer is disposed around a pad located in an outermost ring, and the solder mask layer covers an edge of the pad. The solder mask layer is disposed, so that higher mechanical reliability can be implemented, thereby enhancing connection strength between the chip and the circuit board structure. The solder mask layer is disposed, so that relatively high mechanical reliability can be implemented between the chip and the circuit board without glue dispensing, thereby effectively avoiding the following problems in pad glue dispensing between the chip and the circuit board structure: dewetting of a solder joint of a glue dispensing element during repair, an adhesive failure of a sensitive element, increases in costs and process complexity, and the like.

In a possible implementation, a glue dispensing port is disposed in the chip mounting region, the glue dispensing port is located at a corner of the chip mounting region, and glue is dispensed to a partial region of the chip mounting region. Mechanical reliability of connection between the chip and the circuit board structure is improved due to disposition of the first pad. To implement higher mechanical reliability, a small amount of glue may be partially dispensed to a region in which a size of a first pad is relatively small or a quantity of first pads is relatively small.

In a possible implementation, glue is dispensed to three corners of the chip mounting region and regions, between two adjacent corners, along side length directions of the chip mounting region.

In a possible implementation, a shape of the first pad is one or more of a strip shape, a triangle, a square, a parallelogram, a trapezoid, a polygon, a circle, an L shape, and a V shape, and the shape of the first pad may be set based on a requirement.

According to a second aspect, this application provides an electronic device, including a chip and the circuit board structure in any one of the foregoing implementations. The chip is mounted at the plurality of pads of the chip mounting region.

According to the circuit board structure provided in this application, a mechanical reliability problem of connection between a large-sized chip and the circuit board structure is resolved, and an amount of glue dispensed between the chip and the circuit board structure can be reduced or even no glue is dispensed between the chip and the circuit board structure, thereby effectively avoiding the following problems in pad glue dispensing between the chip and the circuit board structure: dewetting of a solder joint of a glue dispensing element during repair, an adhesive failure of a sensitive element, a dendrite short circuit of a high-temperature and high-humidity solder joint, capacitor acoustic noise, increases in costs and process complexity, and the like.

### BRIEF DESCRIPTION OF DRAWINGS

FIG. 1 is a schematic diagram of an application environment of a circuit board structure according to an implementation of this application;
FIG. 2 is a schematic diagram of a structure in which a chip is soldered to a circuit board according to an implementation of this application;
FIG. 3a is a schematic diagram of a circuit board structure according to an implementation of this application;
FIG. 3b is a schematic diagram of a structure in which pads on a chip side are correspondingly disposed with first pads on a circuit board according to an implementation of this application;
FIG. 4 is a schematic diagram of a structure in which a ground pad is connected to a ground plane according to an implementation of this application;
FIG. 5 is a schematic diagram of a distribution structure of non-functional pads according to an implementation of this application;
FIG. 6 is a schematic diagram of a distribution structure of network function pads according to an implementation of this application;
FIG. 7 is a schematic diagram of a distribution structure of different types of pads according to an implementation of this application;
FIG. 8 is a schematic diagram of a circuit board structure according to another implementation of this application;
FIG. 9 is a schematic diagram of a structure of a distribution region of first pads according to an implementation of this application;
FIG. 10 is a schematic diagram of a structure of a distribution region of first pads according to another implementation of this application;
FIG. 11 is a schematic diagram of a structure of partial glue dispensing of a circuit board structure according to an implementation of this application;
FIG. 12 is a schematic diagram of a structure of a pad for which a solder mask layer is disposed according to an implementation of this application; and
FIG. 13 is a schematic diagram of a solder mask layer according to an implementation of this application.

### DESCRIPTION OF EMBODIMENTS

The following clearly describes specific implementations of this application with reference to the accompanying drawings.

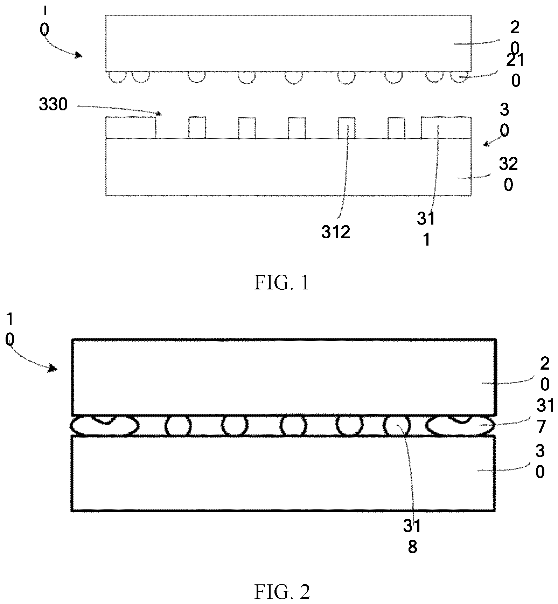

This application provides a circuit board structure and an electronic device. As shown in FIG. 1 and FIG. 2, an electronic device 10 includes a chip 20 and a circuit board structure 30. The electronic device 10 may be a product such as a mobile phone, a watch, or a tablet computer. The chip 20 may be a chip in a packaged form, a power management chip, or the like. Chip pads 210 are disposed on a side of the chip 20, large-sized first pads 311 and small-sized second pads 312 are disposed on a side of the circuit board structure 30, and the chip 20 is mounted on the circuit board structure 30. Specifically, all the independent small-sized second pads 312 in a central region of the circuit board structure 30 are in a one-to-one correspondence with the chip pads 210 of the chip 20, and the large-sized first pad 311 in an edge region of the circuit board structure 30 corresponds to at least two chip pads 210. An area of the large-sized first pad 311 in the edge region is greater than an area of the small-sized second pad 312 in the central region, thereby enhancing mechanical reliability of connection between the chip 20 and the circuit board structure 30. Therefore, the chip 20 is more firmly mounted on the circuit board structure 30, to avoid a case in which pads 310 crack during falling, and consequently the chip 20 is disconnected from the circuit board structure 30, affecting a function of the electronic device 10.

The chip 20 is soldered to the circuit board structure 30 by using solder. After the chip 20 is mounted to the circuit board structure 30, the solder forms solder balls (large-sized solder balls 317 and small-sized solder balls 318, with reference to FIG. 2). A side that is of each large-sized solder ball 317 and that is adjacent to the chip 20 corresponds to at least two chip pads 210, a side that is of each large-sized solder ball 317 and that is adjacent to the circuit board structure 30 corresponds to one large-sized first pad 311 in the edge region, and a side that is of each small-sized solder ball 318 and that is adjacent to the chip 20 corresponds to one chip pad 210, and a side that is of each small-sized solder ball 318 and that is adjacent to the circuit board structure 30 corresponds to one small-sized second pad 312 in the central region (with reference to FIG. 1).

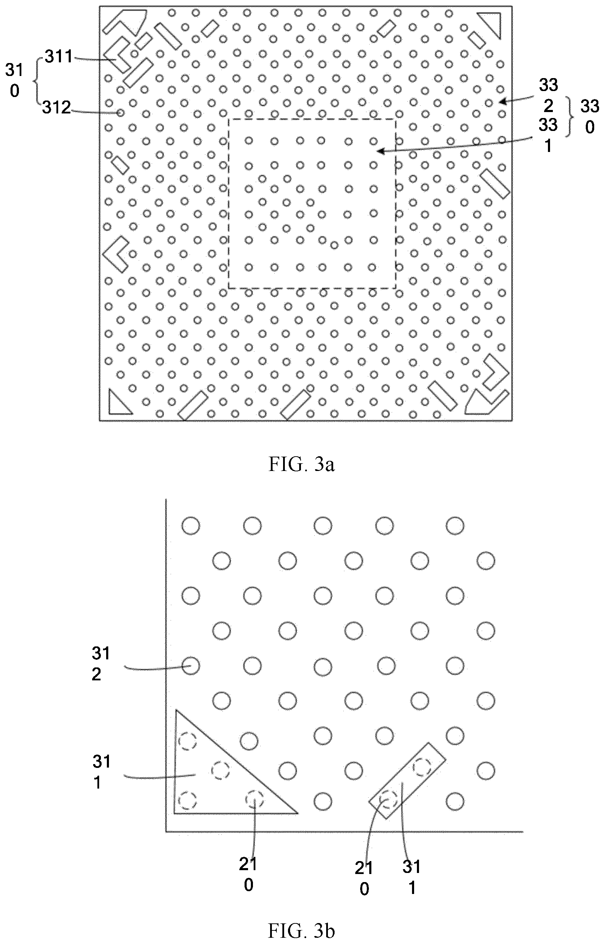

As shown in FIG. 1 and FIG. 3a, the circuit board structure 30 includes a main body 320 and a plurality of pads 310. A chip mounting region 330 is disposed on a surface of the main body 320, the chip mounting region 330 is square, and the chip mounting region 330 includes a central region 331 and an edge region 332 (an edge position). The edge region 332 is in a frame shape and surrounds the central region 331, and a plurality of rings of pads 310 are distributed in the edge region 332. The plurality of pads 310 include at least one first pad 311 and a plurality of second pads 312. The at least one first pad 311 is located in the edge region 332 of the chip mounting region 330, the plurality of second pads 312 are distributed in the central region 331 of the chip mounting region 330 and around the at least one first pad 311, and an area of the first pad 311 is twice greater than an area of the second pad 312. The first pad 311 is configured to solder at least two independent chip pads 210 on a chip side. For example, the first pad 311 may correspond to two independent chip pads 210 (with reference to FIG. 3b, the first pad is a rectangular first pad 311 in FIG. 3b), or the first pad 311 may correspond to four independent chip pads 210 (with reference to FIG. 3b, the first pad is a triangular first pad 311 in FIG. 3b). The chip 20 is fastened to the circuit board structure 30 through mounting. When a size of the chip 20 is relatively large (a size of the chip mounting region 330 is relatively large), in a falling process of the circuit board structure 30, due to being subject to a relatively large stress, pads 310 in the edge region 332 have poor reliability and are prone to crack, and consequently the large-sized chip 20 is disconnected from the circuit board structure 30, affecting a product function. In this application, the large-sized first pad 311 is disposed in the edge region 332, thereby increasing bonding areas between the pads and the chip 20 and the chip mounting region 330 on the surface of the main body 320 of the circuit board structure 30. Therefore, the pads in the edge region are not prone to crack, to help improve mechanical reliability of connection between the chip 20 and the circuit board structure 30, thereby effectively avoiding a case in which the pads crack during falling, and consequently the large-sized chip 20 is disconnected from the circuit board structure 30.

In a possible implementation, an area of the first pad 311 is twice greater than an area of the second pad 312. When the area of the first pad 311 is twice greater than the area of the second pad 312, the increase in the area of the first pad 311 helps improve mechanical reliability of connection between the chip 20 and the circuit board structure 30.

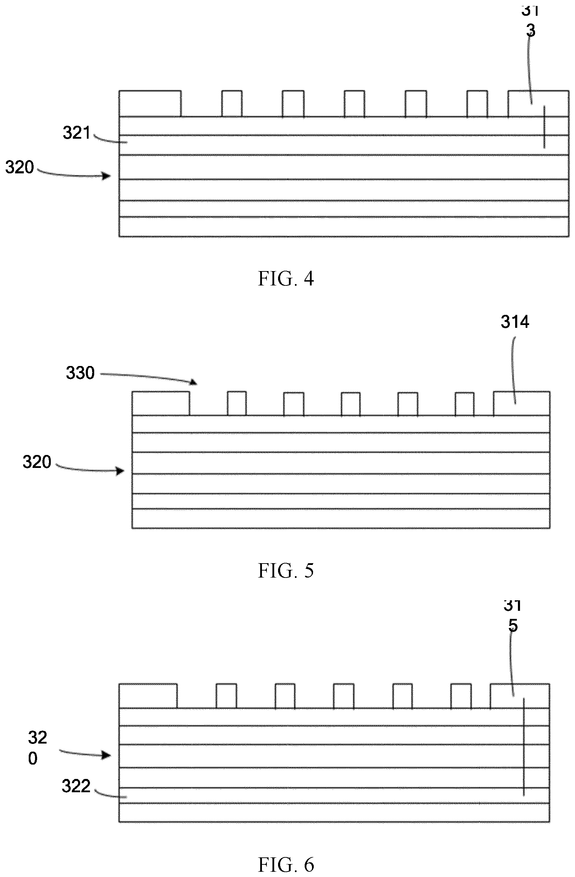

In a possible implementation, the at least one first pad may be a ground pad 313, and the ground pad 313 is electrically connected to a ground plane 321 of the main body 320 (with reference to FIG. 4); the at least one first pad may be a non-functional pad 314, and the non-functional pad 314 is usually disposed at four corners and an outside ring of the chip mounting region 330, to physically connect the chip 20 and the circuit board structure 30, thereby protecting functional pads inside the chip 20 from first cracking when being subjected to mechanical and environmental stresses, affecting a product function (with reference to FIG. 5); or the at least one first pad may be a network function pad 315, the network function pad 315 is electrically connected to a signal plane 322 of the main body 320, and pads having a same network function may be combined into a large-sized first pad (with reference to FIG. 6).

In a possible implementation, a plurality of independent ground pads 313, a plurality of independent non-functional pads 314, or a plurality of independent network function pads 315 having a same network function may be combined into a large-sized first pad 311. It may be understood that, compared with completely using a plurality of independent pads, a quantity of pads on the circuit board structure 30 is reduced after the combination. Processing costs of the circuit board structure 30 are usually related to the quantity of pads, and a larger quantity of pads indicates higher costs. Therefore, the reduction in the quantity of pads that is implemented after the combination (use of the large-sized first pad) helps reduce the processing costs of the circuit board structure 30.

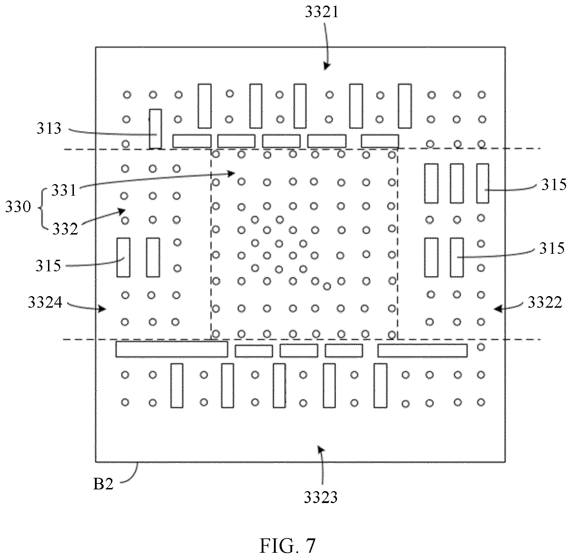

In a possible implementation, in the chip mounting region 330 (with reference to FIG. 7), first pads are mainly distributed in the edge region 332. A plurality of independent ground pads may be combined into a large-sized ground pad 313 (a first pad is a ground pad 313), and a plurality of independent pads having a same function network may be combined into a large-sized same-network-function pad 315 (a first pad is a same-network-function pad 315). The chip mounting region 330 includes a first side edge region 3321, a second side edge region 3322, a third side edge region 3323, and a fourth side edge region 3324 that are located on a periphery of the central region 331 and that are sequentially connected, the first side edge region 3321 and the third side edge region 3323 are oppositely disposed on two sides of the central region 331, the second side edge region 3322 and the fourth side edge region 3324 are oppositely disposed on two sides of the central region 331, first pads (large-sized ground pads 313) electrically connected to the ground plane of the main body are mainly distributed in the first side edge region 3321 and the third side edge region 3323, and same-network-function pads 315 are mainly distributed in the second side edge region 3322 and the fourth side edge region 3324.

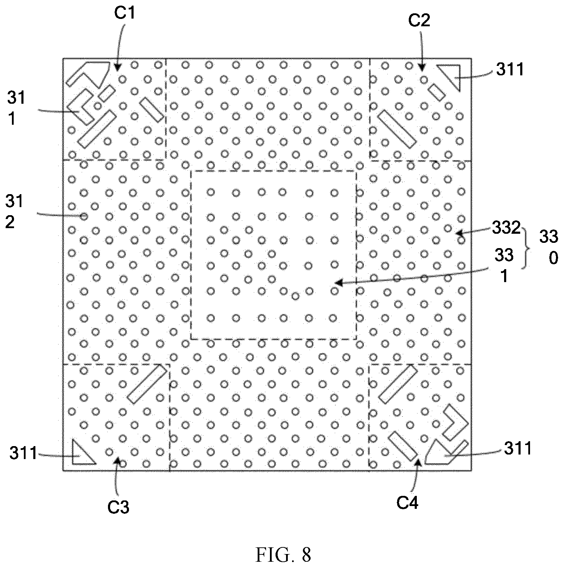

In a possible implementation, the chip mounting region 330 in a square structure is divided into an N^{∗}N matrix region, and first pads 311 are located at four corners of the chip mounting region 330. Because pads in an 8^{∗}8 matrix region C1, an 8^{∗}8 matrix region C2, an 8^{∗}8 matrix region C3, and an 8^{∗}8 matrix region C4 at the corners are prone to crack, the large-sized first pads 311 are mainly distributed in the 8^{∗}8 matrix region C1, the 8^{∗}8 matrix region C2, the 8^{∗}8 matrix region C3, and the 8^{∗}8 matrix region C4 at the four corners, to improve mechanical reliability of connection between the chip 20 and the circuit board structure 30 (with reference to FIG. 8).

In a possible implementation, first pads 311 are distributed at four corners of the square chip mounting region 330, and a size of each first pad 311 is twice to four times a size of the second pad 312. A soldering tin flow direction in a combination and soldering process of more than four pads is uncontrollable, and consequently soldering effect consistency is poor, and poor soldering such as separation between soldering tin and a component-side pad is prone to occur. A pad at a corner is prone to crack when being subjected to mechanical and environmental stresses. Therefore, the first pads 311 distributed at the four corners each are formed by combining two to four second pads 312. The distribution of the first pads 311 at the four corners helps improve mechanical reliability of connection between the chip 20 and the circuit board structure 30, thereby enhancing connection strength between the chip 20 and the circuit board structure 30.

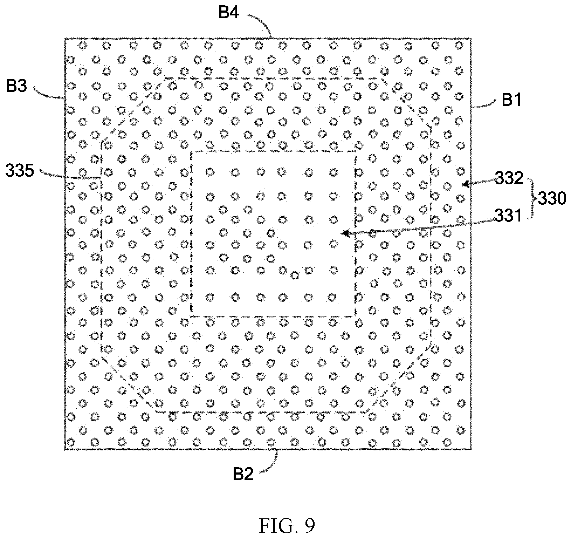

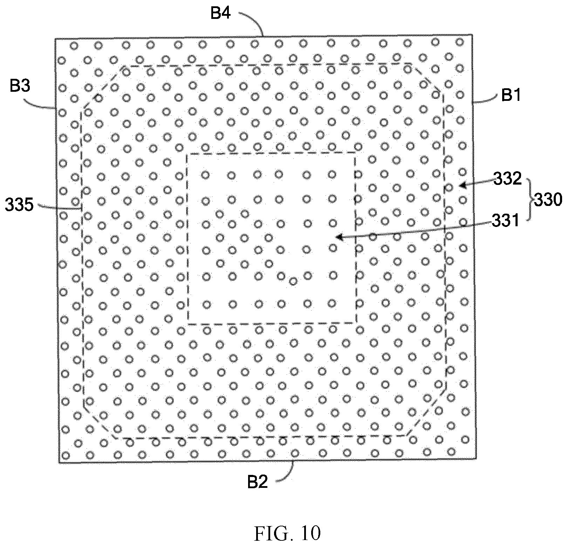

In a possible implementation, when a size of the chip is relatively large, independent pads need to be combined into a larger-sized first pad. A length of the chip is L, a width of the chip is W, and the chip mounting region 330 is divided into an N^{∗}N matrix region. When L^{∗}W>11 mm^{∗}11 mm, pads in outermost three rings of an edge region and outermost five rows of corners in the N^{∗}N matrix are used to be combined into large-sized first pads (with reference to FIG. 9, the first pads may be located in a region between an octagonal dashed-line box 335 and a boundary B1, a boundary B2, a boundary B3, and a boundary B4 of the chip mounting region 330 in FIG. 9). **When 11 mm^{∗}11 mm≥L^{∗}W>8 mm^{∗}8 mm, pads in outermost two rings of an edge region and outermost three rows** of corners in the N^{∗}N matrix are used to be combined into large-sized first pads (with reference to FIG. 10, the first pads may be located in a region between an octagonal dashed-line box 335 and a boundary B1, a boundary B2, a boundary B3, and a boundary B4 **of the chip mounting region 330 in** **FIG. 10****). When L^{∗}W<8 mm^{∗}8 mm, because a** size of the chip 20 is relatively small (a size of the chip mounting region is relatively small), no first pad may be disposed, that is, a plurality of independent pads may not be combined.

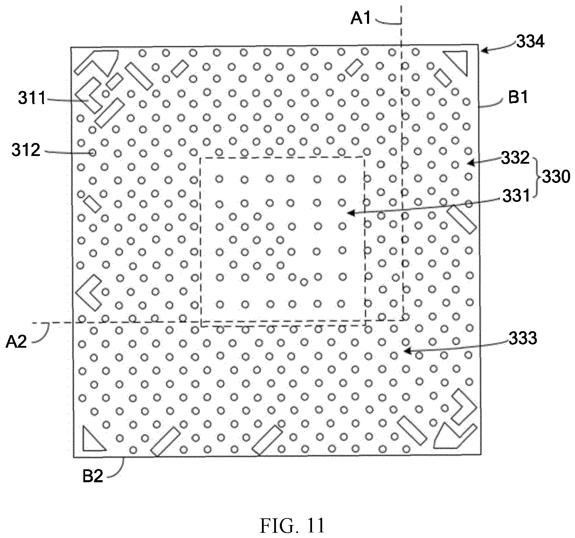

In a possible implementation, large-sized first pads 311 are disposed in the edge region, thereby improving mechanical reliability of connection between the chip 20 and the circuit board structure 30. To meet a higher mechanical reliability requirement, a small amount of glue may be partially dispensed to a region (a glue dispensing region 333, with reference to FIG. 11) in which a size of a first pad 311 is relatively small or a quantity of first pads 311 is relatively small, thereby further enhancing mechanical reliability. Specifically, a glue dispensing port 334 is disposed in the chip mounting region 330, the glue dispensing port 334 is located at a corner of the chip mounting region 330, and glue is dispensed to three corners of the chip mounting region 330 and regions, between two adjacent corners, along side length directions (a boundary B1 and a boundary B2) of the chip mounting region. A vertical distance between an internal boundary A1 of the glue dispensing region 333 and the boundary B1 of the chip mounting region 330 is less than half a length of the boundary B2, and a vertical distance between an internal boundary A2 of the glue dispensing region 333 and the boundary B2 of the chip mounting region 330 is less than half a length of the boundary B1. Compared with a large area of glue dispensing required for using a plurality of independent pads (conventional glue dispensing requires that more than 80% of a region between the chip 20 and the circuit board structure 30 should be filled with glue to ensure mechanical reliability during falling), in this application, the large-sized first pads 311 are disposed in the edge region, thereby significantly enhancing connection strength (improving mechanical reliability) between the chip 20 and the circuit board structure 30. Therefore, provided that more than 50% of the region between the chip 20 and the circuit board structure 30 or even a smaller region is filled with glue, mechanical reliability during falling can be ensured, thereby effectively reducing difficulty of implementing a glue dispensing effect. For a specific glue dispensing position, pad falling stress simulation and pad slicing results further need to be considered, and glue is preferably dispensed to a region in which a simulation stress is relatively high and a region in which it is found, through slicing, that a functional pad completely cracks.

In a possible implementation, a shape of the first pad 311 may be one or more of a strip shape, a triangle, a square, a parallelogram, a trapezoid, a polygon, a circle, an L shape, and a V shape, and the shape of the first pad 311 may be disposed in the edge region of the chip mounting region based on a requirement.

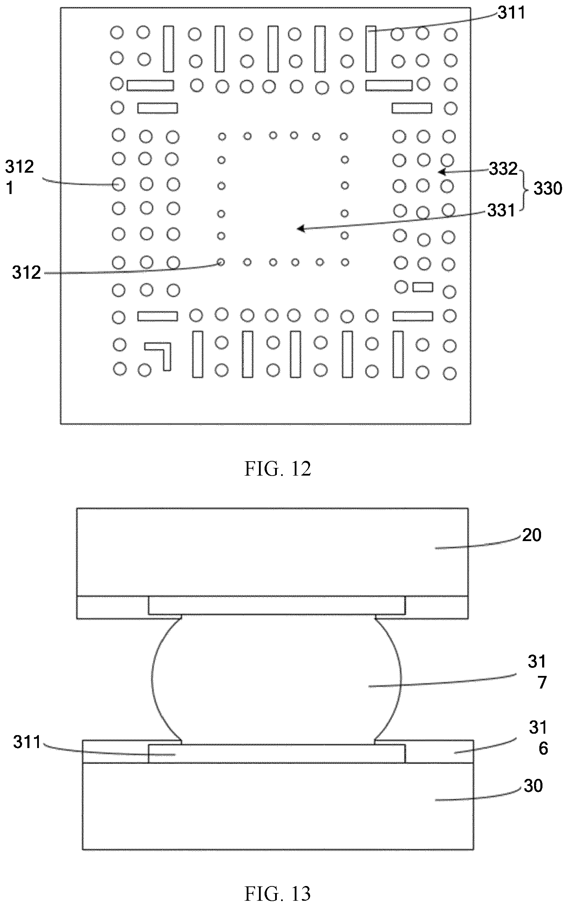

As shown in FIG. 12 and FIG. 13, the first pads 311 are distributed in the edge region 332, and solder mask layers 316 are disposed around independent pads located in an outside ring (circles in FIG. 12 all represent pads, an outside large circle represents a solder mask define (SMD, solder mask define) pad 3121, and an inside small circle represents an independent non-solder mask define (NSMD, non-solder mask define) pad, namely, a second pad 312) and the first pads 311. A solder mask layer around the first pad 311 is used as an example (with reference to FIG. 13). The solder mask layer 316 covers an upper surface of an edge of the first pad 311, the solder mask layer 316 and the upper surface of the first pad 311 jointly form limiting space (form a groove structure), and a solder ball 317 is located in the limiting space. When the solder ball 317 is soldered, soldering tin is filled in the limiting space to enhance a bonding force between the solder ball 317 and the first pad 311. Disposition of a solder mask layer around the independent pad in the outside ring is the same as the disposition of the solder mask layer around the first pad 311. After the solder mask layer is disposed around the independent pad in the outside ring, a solder mask define pad 3121 is formed. The solder mask layer 316 is disposed, so that higher mechanical reliability can be implemented, thereby enhancing connection strength between the chip 20 and the circuit board structure 30.

In a possible implementation, a height, for example, 80 µm, of a solder ball 317 (the solder ball 317 is solder for soldering the chip 20 to the pads on the circuit board structure 30, and the height of the solder ball 317 is a solder size of the solder ball 317 in a direction perpendicular to the mainly body of the circuit board structure) corresponding to the first pad 311 (a large-sized first pad 311 formed by combining a plurality of independent pads 310) may be lower than a height, for example, 180 µm, of a solder ball in a case in which only a plurality of independent pads are disposed. The height of the solder ball 317 may be alternatively disposed based on a specific requirement.

In a possible implementation, the large-sized first pads 311 are disposed in the edge region 332, and the solder mask layers 316 are disposed in the outside ring and the corners, thereby effectively improving mechanical reliability. Therefore, a mechanical reliability requirement of a product can be met without glue dispensing between the chip and the circuit board, thereby effectively avoiding the following problems in pad glue dispensing between the chip and the circuit board structure: dewetting of a solder joint of a glue dispensing element during repair, an adhesive failure of a sensitive element, a dendrite short circuit of a high-temperature and high-humidity solder joint, capacitor acoustic noise, increases in costs and process complexity, and the like. Specifically, due to no glue dispensing, during heating repair, no glue with a high coefficient of thermal expansion squeezes a melted or nearly-melted pad, and therefore the chip is not separated from the pad, so that a failure problem caused due to dewetting of a solder joint during repair does not occur. Due to no glue dispensing, a side wall of an adhesive sensitive element (for example, a WLCSP or an inductor) near the glue dispensing element is not subjected to a pulling force of glue under a mechanical or temperature change, so that an adhesive failure problem of the sensitive element does not occur. Due to no glue dispensing, there is no glue dispensing cavity, and condensation cannot be formed because a temperature between solder joints is kept consistent with that of the outside world, that is, humidity is lower than that in a glue dispensing cavity scenario. Therefore, a dendrite growth speed can be reduced, so that a dendrite short circuit problem of a high-temperature and high-humidity solder joint does not exist. Simulation shows that amplitude that is of a capacitor and that is obtained before glue dispensing is only 1/3500 of that in a glue dispensing case. Therefore, without glue dispensing, capacitor acoustic noise is usually not large enough to be perceived by a human ear.

In this application, the first pad is disposed in the edge region of the chip mounting region, and the size of the first pad is greater than the size of the second pad, thereby resolving a mechanical reliability problem of connection between a large-sized chip and the circuit board structure. Due to enhancement of mechanical reliability, an amount of glue dispensed between the chip and the circuit board structure can be reduced or even no glue is dispensed between the chip and the circuit board structure, thereby effectively avoiding the following problems in pad glue dispensing between the chip and the circuit board structure: dewetting of a solder joint of a glue dispensing element during repair, an adhesive failure of a sensitive element, a dendrite short circuit of a high-temperature and high-humidity solder joint, capacitor acoustic noise, increases in costs and process complexity, and the like.

The foregoing descriptions are merely some embodiments and implementations of this application, but the protection scope of this application is not limited thereto. Any variation or replacement readily figured out by a person skilled in the art within the technical scope disclosed in this application shall fall within the protection scope of this application.

## Claims

1. A circuit board structure, comprising a main body and a plurality of pads, wherein a chip mounting region is disposed on a surface of the main body, the plurality of pads comprise at least one first pad and a plurality of second pads, the at least one first pad is located near an edge of the chip mounting region, the plurality of second pads are distributed in a central region of the chip mounting region and around the at least one first pad, an area of the first pad is twice greater than an area of the second pad, and the first pad is configured to solder at least two independent pads on a chip side.

2. The circuit board structure according to claim 1, wherein the at least one first pad is electrically connected to a ground plane of the main body, the at least one first pad is a non-functional pad, or the at least one first pad is a network function pad.

3. The circuit board structure according to claim 2, wherein the chip mounting region comprises a first side edge region, a second side edge region, a third side edge region, and a fourth side edge region that are located on a peripheral of the central region and that are sequentially connected, the first side edge region and the third side edge region are oppositely disposed on two sides of the central region, the second side edge region and the fourth side edge region are oppositely disposed on two sides of the central region, first pads electrically connected to the ground plane of the main body are distributed in the first side edge region and the third side edge region, and network function pads are distributed in the second side edge region and the fourth side edge region.

4. The circuit board structure according to claim 2, wherein the network function pad is electrically connected to a signal plane of the main body.

5. The circuit board structure according to claim 1, wherein the chip mounting region is square, first pads are distributed at four corners of the chip mounting region, and a size of each first pad is twice to four times a size of the second pad.

6. The circuit board structure according to claim 1, wherein the chip mounting region is square, the chip mounting region is divided into an N^{∗}N matrix region, first pads are located at four corners of the chip mounting region, and the first pads are distributed in 8^{∗}8 matrix regions.

7. The circuit board structure according to claim 5 or 6, wherein the chip mounting region comprises the central region and an edge region, the edge region is in a frame shape and surrounds the central region, a plurality of rings of pads are distributed in the edge region, the first pads are distributed in the edge region, a solder mask layer is disposed around a pad located in an outermost ring, and the solder mask layer covers an edge of the pad.

8. The circuit board structure according to claim 5 or 6, wherein a glue dispensing port is disposed in the chip mounting region, the glue dispensing port is located at a corner of the chip mounting region, and glue is dispensed to a partial region of the chip mounting region.

9. The circuit board structure according to claim 8, wherein glue is dispensed to three corners of the chip mounting region and regions, between two adjacent corners, along side length directions of the chip mounting region.

10. The circuit board structure according to claim 5 or 6, wherein a shape of the first pad is one or more of a strip shape, a triangle, a square, a parallelogram, a trapezoid, a polygon, a circle, an L shape, and a V shape.

11. An electronic device, comprising a chip and the circuit board structure according to any one of claims 1 to 10, wherein the chip is mounted at the plurality of pads of the chip mounting region.
